# EUROPEAN PATENT APPLICATION

(11) **EP 4 071 881 A1**
(43) Date of publication of application: **12.10.2022**
(21) Application number: 20895396.8
(22) Date of filing: 29.07.2020
(51) Int. Cl.: H01M 10/42, H01M 10/48, G01R 31/389, G01R 31/392

(54) **STORAGE BATTERY DEVICE, METHOD, AND PROGRAM**

(30) Priority: 06.12.2019 JP 2019221554
(71) Applicant: Toshiba Infrastructure Systems & Solutions Corporation, Kawasaki-shi, Kanagawa 212-0013 (JP); KABUSHIKI KAISHA TOSHIBA, Minato-ku Tokyo 105-0023 (JP)
(72) Inventor: KONDO, Atsumi, Kawasaki-shi, Kanagawa 212-0013 (JP); KARASAWA, Motoya, Kawasaki-shi, Kanagawa 212-0013 (JP); YAMAZAKI, Osamu, Kawasaki-shi, Kanagawa 212-0013 (JP)
(74) Representative: AWA Sweden AB
(86) International application number: PCT/JP2020/029121
(87) International publication number: WO 2021/111673

(57) **Abstract**

A storage battery device of an embodiment includes a plurality of cell modules including a plurality of battery cells, a data acquirer configured to acquire voltage data of the battery cells, a calculator configured to calculate a rise rate of an internal resistance value with respect to a default value according to the voltage data of the battery cells, and a storage configured to store therein the rise rate of the internal resistance value with respect to the default value.

## Description

### FIELD

Embodiments of the present invention relate to a storage battery device, a method, and a program.

### BACKGROUND

In recent years, along with the progress of a storage battery technology including lithium-ion secondary batteries, application of storage batteries to a large-scale power storage system has been considered.

As an example, a single lithium-ion secondary battery cell has a storage capacity of about several Wh. To attain an MWh storage battery device, several thousands to several tens of thousands of cells are to be arranged in series and in parallel to exert desired voltage and current capacity.

In such a case, a generally adopted method is to combine a large number of battery modules in a unit of about several 10 V and several 10 A and collectively monitor states of all the battery modules using a battery management system (BMU).

### CITATION LIST

### PATENT LITERATURE

Patent Literature 1: JP H11-003486A

### SUMMARY OF THE INVENTION

### PROBLEM TO BE SOLVED BY THE INVENTION

In deterioration diagnosis of a storage battery device, a variation in internal resistance value over time and arising from a usage history is measured. In the case of a battery with an internal resistance value to be doubled in ten years, for example, a variation in internal resistance per year is about 10%.

Batteries for use in railways or railroads are likely to increase in internal resistance value through repeated charging and discharging. When the number of operating days are 270 days a year, the internal resistance value increases only by 10%/270 = 0.037%/day. It is thus not effective to frequently collect internal resistance data.

In view of the foregoing, the present invention provides a storage battery device, a method, and a program that can collect data sufficient for deterioration diagnosis while reducing a storage capacity by reducing the amount of sampling data.

### Means for Solving Problem

According to one embodiment, in general, a storage battery device includes a plurality of cell modules including a plurality of battery cells, a data acquirer configured to acquire voltage data of the battery cells, a calculator configured to calculate a rise rate of an internal resistance value with respect to a default value, from the voltage data of the battery cells, and a storage configured to store therein the rise rate of the internal resistance value with respect to the default value.

### BRIEF DESCRIPTION OF DRAWINGS

FIG. 1 is an explanatory diagram of the principle of an embodiment;
FIG. 2 is a schematic configuration block diagram of a storage battery system including a storage battery device of an embodiment;
FIG. 3 is an explanatory diagram of an operation in a first embodiment; and
FIG. 4 is an explanatory diagram of an operation in a second embodiment.

### DETAILED DESCRIPTION

The following will describe a storage battery device of an embodiment in detail with reference to the accompanying drawings.

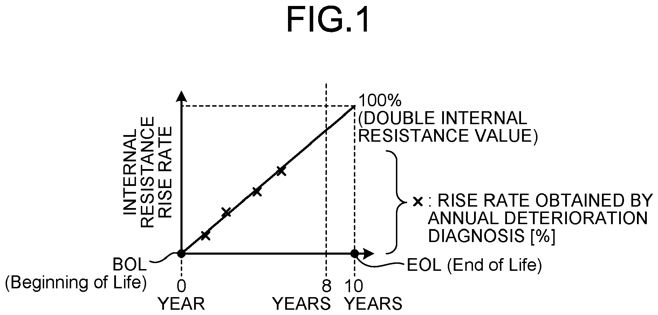

First, the principle of an embodiment will be described. FIG. 1 is an explanatory diagram of the principle of an embodiment.

The battery deterioration diagnosis requires obtainment of a signal (rectangular wave signal) for about several minutes, the signal turning to a constant current before a rising of charge or discharge current of the battery. A rise rate of battery internal resistance can be calculated by measuring a voltage of each battery cell during the several-minute period.

In view of this, a high-order main circuit sets a start and end trigger to a rectangular wave signal, to record and store only a constant current waveform that allows easy calculation of an internal resistance rise rate. This makes it possible to substantially reduce the memory capacity for status diagnostics.

Specifically, as illustrated in FIG. 1, in the case of a battery cell designed to increase in internal resistance twice the initial value in ten years, the internal resistance value increases by 10% in about one year.

More specifically, batteries for use in railways or railroads are likely to increase in internal resistance through repeated charging and discharging. When the number of operating days is 270 days, for example, the increase rate of internal resistance per day is expected to be only 10%/270 = 0.037%/day.

That is, it is not necessary to store internal resistance data every day. Specifically, it is possible to adequately know a rising trend of the internal resistance by measuring the internal resistance at least once or several times a year and storing and plotting results of the measurement.

Thereby, it is possible to substantially reduce the memory capacity for the status diagnostics of battery cells.

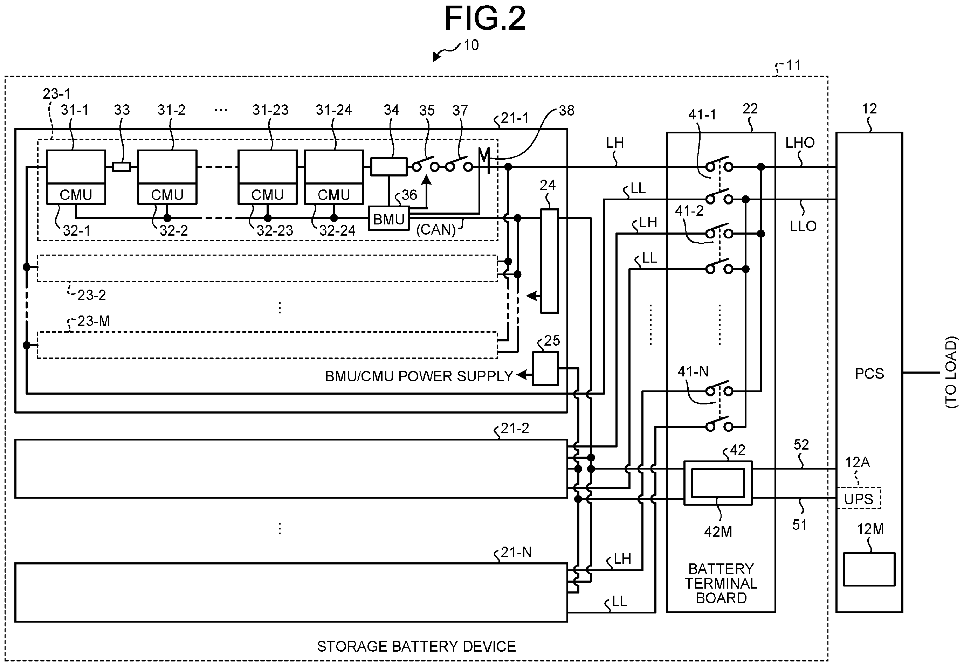

FIG. 2 is a schematic configuration block diagram of a storage battery system including a storage battery device of an embodiment.

The storage battery system 10 generally includes a storage battery device 11 that stores power, and a power conditioning system (PCS) 12 that receives and converts direct-current power from the storage battery device 11 into alternating-current power having desired electric quality, and supplies the alternating-current power to a load.

The storage battery device 11 generally includes a plurality of battery boards 21-1 to 21-N (N is a natural number) and a battery terminal board 22 connected to the battery boards 21-1 to 21-N.

The battery boards 21-1 to 21-N each include a plurality of battery units 23-1 to 23-M (M is a natural number) connected to each other in parallel, a gateway device 24, and a direct-current power supply 25 that supplies direct-current power for operation to a battery management unit (BMU) and a cell monitoring unit (CMU) to be described later.

A configuration of the battery unit will be now described.

Each of the battery units 23-1 to 23-M is connected to output power lines (bus lines) LHO and LLO via a high-potential-side power supply line LH and a low-potential-side power supply line LL, to supply power to the power conditioning system 12 serving as a main circuit.

The battery units 23-1 to 23-M have the same configuration, therefore, the battery unit 23-1 will be described as an example.

The battery unit 23-1 generally includes a plurality of (24 in FIG. 1) cell modules 31-1 to 31-24, a plurality of (24 in FIG. 2) CMUs 32-1 to 32-24 included in the respective cell modules 31-1 to 31-24, a service disconnect 33, a current sensor 34, a contactor 35, a fuse 37, and a current sensor 38. The cell modules 31-1 to 31-24, the service disconnect 33, the current sensor 34, and the contactor 35 are connected to one another in series.

The cell modules 31-1 to 31-24 constitute assembled batteries of battery cells connected in series-parallel. The series-connected cell modules 31-1 to 31-24 constitute an assembled battery group.

The battery unit 23-1 further includes a BMU 36 which is connected to communication lines of the respective CMUs 32-1 to 32-24 and an output line of the current sensor 34.

Under the control of the gateway device 24, the BMU 36 controls the battery unit 23-1 as a whole, and performs open/close control of the contactor 35 according to a result of communications (voltage data and temperature data as described later) with each of the CMUs 32-1 to 32-24, and a result of detection of the current sensor 34.

Next, a configuration of the battery terminal board will be described.

The battery terminal board 22 includes a plurality of board breakers 41-1 to 41-N corresponding to the battery boards 21-1 to 21-N, and a master device 42 serving as a microcomputer that controls the storage battery device 11 as a whole.

The master device 42 and the power conditioning system 12 are connected together through a control power line 51 for supplying power via an uninterruptible power system (UPS) 12A of the power conditioning system 12 and a control communication line 52 serving as the Ethernet (registered trademark) to exchange control data.

In such a configuration, the CMUs 32-1 to 32-24 function as a data acquirer that acquires voltage data of the battery cells included in the cell modules 31-1 to 31-24. The master device 42 or the PCS 12 functions as a calculator that calculates a rise rate of an internal resistance value with respect to a default value from the voltage data of the battery cells

Further, a memory 42M of the master device 42 or a memory 12M of the PCS 12 functions as a storage that stores therein the rise rate of the internal resistance value with respect to the default value.

### [1] First Embodiment

An operation of a first embodiment will be now described.

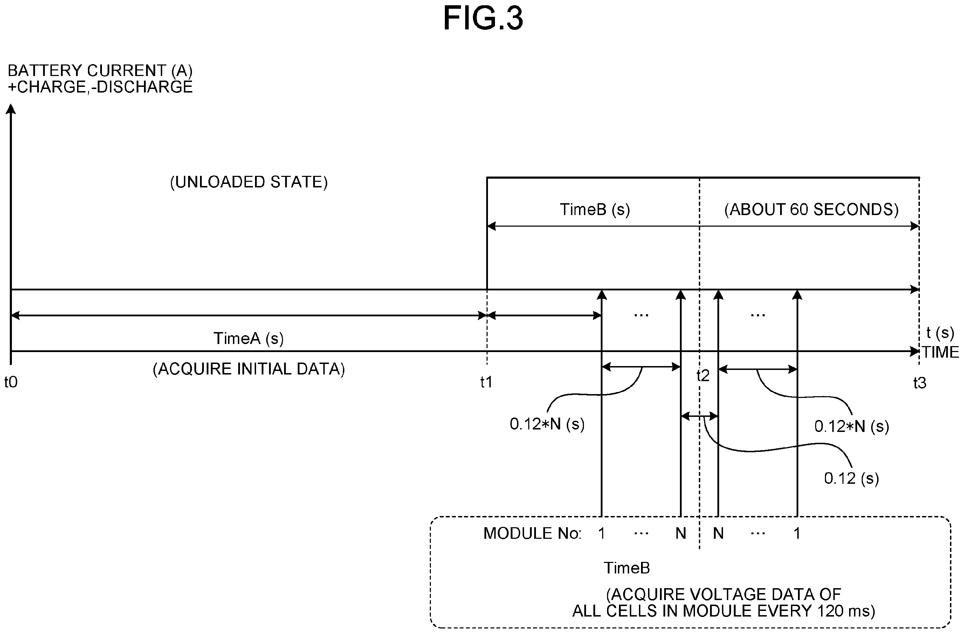

FIG. 3 is an explanatory diagram of an operation of the first embodiment.

The following will describe an example that the PCS 12 functions as a calculator for the internal resistance value, and the memory 12M functioning as a storage that stores therein the rise rate of the internal resistance value with respect to the default value.

The PCS 12 functioning as a calculator for the internal resistance value receives data of the battery cells constituting the cell modules 31-1 to 31-24 from the CMUs 32-1 to 32-24 and acquires temperatures, voltages (= voltages of all the battery cells included in the cell modules), and SOC data of the cell modules 31-1 to 31-24 in a non-loaded state (t0 to t1) from among the received data.

Thereby, the PCS 12 functioning as a calculator calculates an open circuit voltage (OCV) of the cell modules 31-1 to 31-24 before a charge current or a discharge current flows through the cell modules 31-1 to 31-24.

Subsequently, the PCS 12 functioning as a calculator acquires voltage data of the cell modules 31-1 to 31-24 during a period from when a charge current or a discharge current starts flowing through the cell modules 31-1 to 31-24 in the non-loaded state to when the cell modules 31-1 to 31-24 are placed in a constant current state and become sufficiently stable (t1 to t3).

Thereby, the PCS 12 functioning as a calculator acquires data of the cell modules 31-1 to 31-24 in transitioning from the non-loaded state to a constant current charging (or discharging) state to calculate the internal resistance from a variation in voltage and a variation in current.

Consequently, the PCS 12 can calculate the internal resistance rise rate of each battery cell from the acquired temperatures, voltages (= voltages of all the battery cells included in the cell modules), and SOC data of the cell modules 31-1 to 31-24 in the non-loaded state as well as the voltage data of each battery cell in the constant current state.

In such a case, by measuring the internal resistance at least once a year, in which the internal resistance rise rate is expected to exhibit a significant difference, it is possible to ensure that a rising trend of the internal resistance is found while preventing an increase in capacity of data to be stored.

As an example, assumed that such data be acquired for one-minute period once to four times a year. In this case it is possible to acquire a sufficient internal resistance rise rate by acquiring data corresponding to about 32 minutes in total alone until overhaul eight years later, for example. In other words, the memory 42M of the master device 42 or the memory 12M of the PCS 12 that stores measurement data can decrease in storage capacity, which makes it possible to facilitate a system construction.

In calculation of the internal resistance rise rate, an error may occur depending on the SOC or temperature of each battery cell. It is thus preferable to use data acquired under the same condition such as at the same SOC and the same temperature, for the calculation. For example, the storage battery system may be configured to be able to acquire data under the same SOC or temperature condition by performing given processing before the measurement or adding a supplementary system.

In addition, to acquire data of each battery cell, during a first period (t1 to t2) as illustrated in FIG. 3, voltage data of the battery cells is measured and acquired at given time intervals (every 120 ms in the example in FIG. 3) in order from the first battery cell on the low voltage side to the N-th battery cell lastly connected on the high voltage side.

During a second period (t2 to t3) after an elapse of a half (60 ms in the example in FIG. 3) of the given length of time, voltage data is measured and acquired at given time intervals (every 120 ms in the example in FIG. 3) in order from the first battery cell on the high voltage side, i.e., the N-th battery cell to the first battery cell lastly connected on the low voltage side.

In this manner, the voltage data is acquired twice. By averaging the two sets of voltage data, thus, the internal resistance value can be more accurately calculated, less affected by a gradual change in the temperatures of the battery cells during charging or discharging.

According to the first embodiment, as described above, it is possible to collect sufficient data for performing a deterioration diagnosis while reducing the amount of sampling data to reduce the storage capacity.

### [2] Second Embodiment

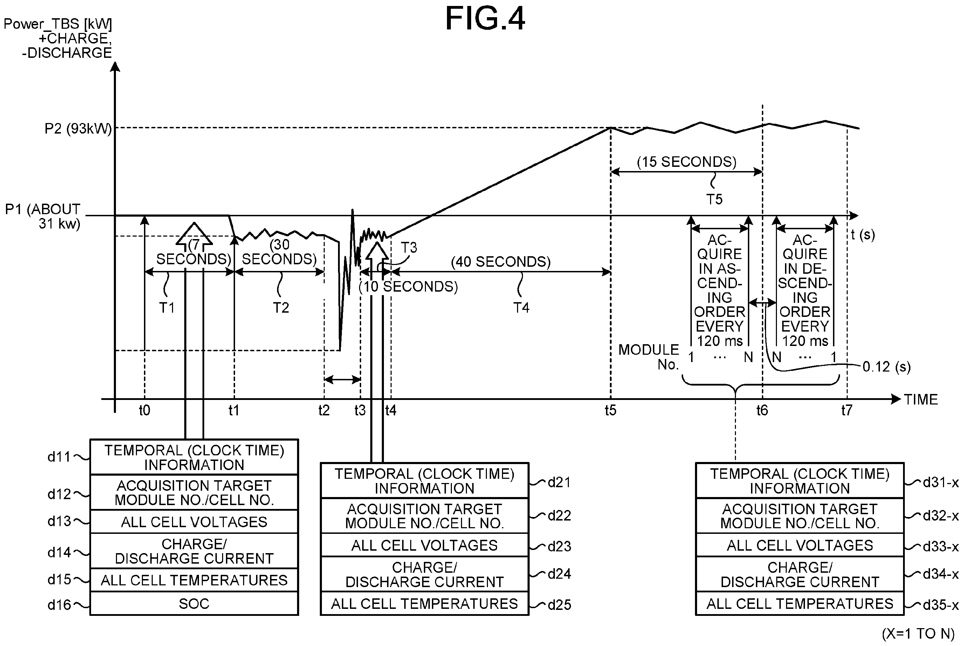

Next, an operation of the second embodiment will be described. FIG. 4 is an explanatory diagram of an operation of a second embodiment.

The second embodiment is different from the first embodiment in that a storage battery device is mounted on a railway vehicle (train engine) and connectable to an external generator.

As with the first embodiment, the following will describe an example that the PCS 12 functions as a calculator for the internal resistance value, and the memory 12M functions as a storage that stores therein the rise rate of the internal resistance value with respect to the default value.

For the sake of better understanding, in the following the storage battery device includes battery units 23-1 to 23-3 capable of individually supplying power of 31 kW, by way of example.

In response to receipt of a start signal from a system of the railway vehicle (not illustrated) at time t0, the PCS 12 functioning as a calculator for the internal resistance value acquires a plurality of pieces of data while any of the battery units (for example, the battery unit 23-1) is supplying power and in the non-loaded state.

Examples of the data to be acquired include temporal (clock time) data d11 of the cell modules 31-1 to 31-24, acquisition target identification data d12 including a module number (No.) and a battery cell number (No.) for identifying a cell module and a battery cell as a subject of data acquisition, voltage data d13 (= voltage data of all the battery cells included in the cell modules), and charge/discharge current data d14 of the overall cell modules 31-1 to 31-24, and temperature data d15 and SOC data d16 of all the battery cells.

Thereby, the PCS 12 functioning as a calculator calculates an open circuit voltage (OCV) of the cell modules 31-1 to 31-24 in the constant-power supply state.

Subsequently, at time t1 the storage battery device starts supplying power to an auxiliary machine of the railway vehicle.

In this case, regarding the battery units 23-1 to 23-3 including the battery cells in series-parallel connection, i.e., two cells in series and twelve cells in parallel, the voltages of the battery cells are measured, for example, in ascending order and then in descending order during a time T1 from time t0 to time t1, which takes about seven seconds to complete the measurement.

At time t2 after an elapse of a given length of time T2 (for example, 30 seconds) from time t1, the auxiliary machine typically transitions to an operating state and performs engine cranking.

At time t3 (for example, time t3 - t2 = 9 seconds) at which engine cranking is performed, the PCS 12 functioning as a calculator for the internal resistance value acquires a plurality of pieces of data again in a loaded state and a non-power generation state.

Examples of data to be acquired include temporal (clock time) data d21, acquisition target identification data d22 including a module number (No.) and a battery cell number (No.) for identifying a cell module and a battery cell as a subject of data acquisition, voltage data d23 (= voltage data of all the battery cells included in the cell modules) and charge/discharge current data d24 of all the cell modules 31-1 to 31-24, and temperature data d25 and SOC data d26 of all the battery cells.

To generate power for charging constant power, the rotation speed of the engine is gradually increased from time t4. Thereby, the cell modules 31-1 to 31-24 are placed in a constant power charging state at time t5. In this case, a time T4 (= t5 - t4) is about 40 seconds, for example.

Thereafter, the PCS 12 functioning as a calculator for the internal resistance value acquires, as to the cell modules 31-1 to 31-24 in the constant power charging state, temporal (clock time) data d31-X (X = 1 to N), acquisition target identification data d32-X including a module number (No.) and a battery cell number (No.) for identifying a cell module and a battery cell as a subject of data acquisition, voltage data d33-X (= voltage data of each of the battery cells included in the cell modules) and charge/discharge current data d34-X of each battery cell, and temperature data d35-X of all the battery cells.

The PCS 12 acquires the voltage data d33-X of the battery cells in first order (for example, from the low voltage side to the high voltage side).

Specifically, the PCS 12 functioning as a calculator for the internal resistance value measures and acquires voltage data at given time intervals (every 120 ms in the example in FIG. 4) in order from the first battery cell on the low voltage side to the N-th battery cell lastly connected on the high voltage side.

At time t6 a half (60 ms in the example in FIG. 4) of the given length of time elapses, and at time after an elapse of the other half of the given length of time, that is, an elapse of the given length of time after the voltage data of the N-th battery cell is acquired, the PCS 12 functioning as a calculator for the internal resistance value acquires the voltage data d33X of the battery cells in second order (for example, from the high voltage side to the low voltage side).

Specifically, the PCS 12 functioning as a calculator for the internal resistance value measures and acquires the voltage data at given time intervals (every 120 ms in the example in FIG. 3) in order from the first battery cell on the high voltage side, i.e., the N-th battery cell, to the first battery cell lastly connected on the low voltage side.

The voltage data is acquired twice as described above for the purpose of reducing an influence of a gradual temperature change occurring during charging and discharging by averaging the two sets of voltage data, as in the first embodiment.

As a result, the PCS 12 can calculate the internal resistance rise rate of each battery cell from the acquired temperatures, voltages (= voltages of all the battery cells included in the cell modules), and SOC data of the cell modules 31-1 to 31-24 in the non-loaded state, and the voltage data of each battery cell in the constant current state.

According to the second embodiment, as described above, it is made possible to ensure that a rising trend of the internal resistance is found by measuring the internal resistance upon startup once an operating day while reducing the capacity of data to be stored. Specifically, merely acquiring data for one-minute period about once a day makes it possible to know the internal resistance rise rate every day, and substantially reduce the storage capacity of the memory 42M of the master device 42 or the memory 12M of the PCS 12 that stores therein the measurement data. This can facilitate a system construction.

According to the second embodiment as described above, it is thus made possible to collect sufficient data for performing a deterioration diagnosis while reducing the storage capacity by reducing the amount of sampling data.

As described above, according to the respective embodiments, it is made possible to collect sufficient data for performing a deterioration diagnosis while reducing the storage capacity by reducing the amount of sampling data.

The storage battery device of the present embodiment has a hardware configuration using a general computer, that is, including a control device such as an MPU, and a storage device such as a read only memory (ROM) or a RAM.

Control programs to be executed by the storage battery device of the present embodiment are recorded and provided in an installable or executable file format on a computer-readable recording medium such as an optical disk such as a digital versatile disk (DVD) or a semiconductor memory device such as a USB memory or a solid state disk (SSD) .

In addition, the control programs to be executed by the storage battery device of the present embodiment may be stored in a computer connected to a network such as the internet and provided by being downloaded via the network. The control programs to be executed by the storage battery device of the present embodiment may be configured to be provided or distributed via a network such as the internet.

In addition, the control programs for the storage battery device of the present embodiment may be incorporated into a ROM or the like in advance.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions.

For example, in the present embodiment the battery units are in one parallel, multiple series connection, however, the battery units may be in multiple parallel, multiple series connection. As for the battery units in multiple parallel, multiple series connection, the parallel-connected cells can be regarded as a single cell and the respective elements execute processing thereto accordingly. In this manner, the solution provided in the present embodiment is applicable to such battery units. The accompanying claims and their equivalents are intended to cover such forms or modifications as would fall within the scope and spirit of the inventions.

### REFERENCE SIGNS LIST

- 10: STORAGE BATTERY SYSTEM
- 11: STORAGE BATTERY DEVICE
- 12: POWER CONDITIONING SYSTEM (PCS)
- 12M: MEMORY
- 21: BATTERY BOARD
- 22: BATTERY TERMINAL BOARD
- 23-1 to 23-M: BATTERY UNIT
- 24: GATEWAY DEVICE
- 25: DIRECT-CURRENT POWER SUPPLY
- 31-1 to 31-24: CELL MODULE
- 32-1 to 32-24: CMU (CELL MONITORING UNIT)
- 36: BMU (BATTERY MANAGEMENT UNIT)
- 37: FUSE
- 38: CURRENT SENSOR

## Claims

1. A storage battery device comprising:
a plurality of cell modules including a plurality of battery cells;
a data acquirer configured to acquire voltage data of the battery cells;
a calculator configured to calculate a rise rate of an internal resistance value with respect to a default value, from the voltage data of the battery cells; and
a storage configured to store therein the rise rate of the internal resistance value with respect to the default value.

2. The storage battery device according to claim 1, wherein
the data acquirer acquires the voltage data of the battery cells while a charge current or a discharge current of the cell modules is in a constant current state.

3. The storage battery device according to claim 1, wherein
the data acquirer acquires the voltage data and temperature data of the battery cells in a period where a charge current or a discharge current of the cell modules rises from a certain value and turns to a constant current, and in a certain period of the charge current or the discharge current in a constant current state.

4. The storage battery device according to claim 1, wherein
the storage battery device is connectable to an external electric generator,
the data acquirer acquires temperatures, voltages, and SOC data of the cell modules in a non-loaded state after the acquisition start timing and while the storage battery device is not connected to the electric generator, and
the calculator calculates an open circuit voltage of the cell modules before a current flows through the cell modules.

5. The storage battery device according to claim 1, wherein
the data acquirer acquires temperatures, voltages, and SOC data of the cell modules in a non-loaded state after the acquisition start timing, and
the calculator calculates an open circuit voltage of the cell modules before a current flows through the cell modules.

6. The storage battery device according to claim 4, wherein
the data acquirer acquires the voltage data and temperature data of the battery cells while the storage battery device is connected to the electric generator and the cell modules are in a constant power charging state.

7. The storage battery device according to claim 2, wherein
the battery cells are connected in series, and
the data acquirer acquires the voltage data of the battery cells at given time intervals in order of connection, and then acquires the voltage data and temperatures of the battery cells at given time intervals in reverse order of the connection.

8. The storage battery device according to claim 6, wherein
the battery cells are connected in series, and
the data acquirer acquires the voltage data of the battery cells at given time intervals in order of connection, and then acquires the voltage data and temperatures of the battery cells at given time intervals in reverse order of the connection.

9. The storage battery device according to claim 1, wherein
the data acquirer acquires the voltage data and temperature data of the battery cells at least once a year to calculate the rise rate of the internal resistance value with respect to the default value.

10. A method to be executed by a storage battery device comprising a storage and a plurality of cell modules including a plurality of battery cells, the method comprising the steps of:
acquiring voltage data and temperature data of the battery cells;
calculating a rise rate of an internal resistance value with respect to a default value according to the voltage data and the temperature data of the battery cells, and a current flowing through the battery cells; and
storing the rise rate of the internal resistance value with respect to the default value in the storage.

11. A program for a computer to control a storage battery device comprising a storage and a plurality of cell modules including a plurality of battery cells, the program comprising:
means for acquiring voltage data and temperature data of the battery cells;
means for calculating a rise rate of an internal resistance value with respect to a default value according to the voltage data and the temperature data of the battery cells, and a current flowing through the battery cells; and
means for storing the rise rate of the internal resistance value with respect to the default value in the storage.
